# EUROPÄISCHE PATENTANMELDUNG

(11) **EP 1 124 231 A1**
(43) Veröffentlichungstag der Anmeldung: **16.08.2001**
(21) Anmeldenummer: 01100894.3
(22) Anmeldetag: 16.01.2001
(51) Int. Cl.: G11C 11/409

(54) **Speicherbaustein mit geringer Zugriffszeit**

(30) Priorität: 31.01.2000 DE 10004109
(71) Anmelder: Infineon Technologies AG, 81669 München (DE)
(72) Erfinder: Schrögmeier, Peter, 81547 München (DE); Dietrich, Stefan, Dr., 82299 Türkenfeld (DE); Partsch, Torsten, Chapel Hill, NC 21514 (US); Hein, Thomas, 81541 München (DE); Heyne, Patrick, 81243 München (DE); Marx, Thilo, 80997 München (DE)
(74) Vertreter: MÜLLER & HOFFMANN Patentanwälte

(57) **Zusammenfassung**

Speicherchips müssen eine möglichst geringe Zugriffszeit auf gespeicherte Daten aufweisen. Um diese Zugriffszeit zu minimieren, wird die Laufzeit eines Bits auf von den Endverstärkern (6) weit entfernten lokalen Datenleitungsstreifen (14) durch mittige Zentrierung der Schalter (10), welche den Verbindungspunkt zwischen lokaler Datenleitung (4) und Hauptdatenleitung (5) darstellen, begrenzt.

## Beschreibung

Die Erfindung betrifft einen Speicherbaustein gemäß dem Oberbegriff des Patentanspruches 1.

Bei Speicherbausteinen, welche synchron getaktet sind, soll auf eine bestimmte Anzahl von gespeicherten Bits gleichzeitig zugegriffen werden. In der Regel sind dies acht, sechzehn oder zweiunddreißig Bits. "Gleichzeitig" bedeutet in diesem Zusammenhang, dass alle Bits, die synchron gelesen werden sollen, innerhalb einer vordefinierten, festen Zeitspanne an einen Ausgang des Speicherbausteins gebracht werden müssen, von wo aus sie als "Informationspaket" im Ganzen weitertransportiert werden. Diese Zeitspanne liegt typischerweise im Nano-Sekunden-Bereich.

Da in einer elektronischen Datenverarbeitungsanlage, wie z. B. einem Computer, die maximale Taktfrequenz durch diejenige Einheit beschränkt ist, die zum Verrichten eines Arbeitsschrittes die maximale Zeit benötigt, darf es keine Einheit geben, die zum Verrichten eines Arbeitsschrittes wesentlich mehr Zeit benötigt als die übrigen Einheiten. Dies bedeutet u. a., dass die Zugriffszeit auf eine gewünschte Anzahl von Bits in einem Speicherchip nicht über der Zeit eines Taktzyklus liegen darf. Wäre dies der Fall, so würde bis zum Weitertransport des Informationspaketes ein Taktzyklus an Zeit mehr benötigt, da das am Ausgang des Speicherchips wartende Informationspaket nur taktweise weitertransportiert werden kann. Die an den Speicherbaustein gekoppelten Verarbeitungseinheiten, die dieses Informationspaket_zum Verrichten ihrer Arbeit benötigen, wären in ihrer Arbeit jeweils einen Taktzyklus lang unterbrochen.

Die Zugriffszeit, die sowohl beim Lesen als auch beim Speichern von Bits benötigt wird, ist also eine Größe, deren Wert so gering wie möglich sein sollte.

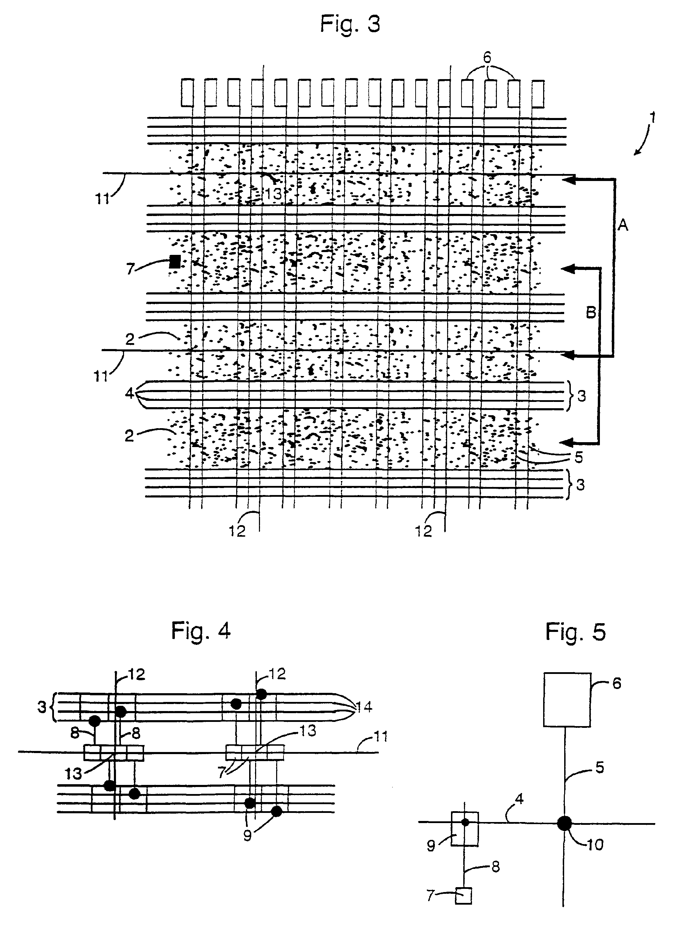

Fig. 3 zeigt einen schematischen Aufbau eines Zellenfeldes 1 eines Speicherbausteins gemäß dem Stand der Technik. Das Zellenfeld 1 besteht aus mehreren Zellenfeldstreifen 2, die durch zu den Zellenfeldstreifen 2 parallele, beidseitig angrenzende lokale Datenleitungsstreifen 3 voneinander getrennt sind. Die Zellenfeldstreifen 2 bestehen im wesentlichen aus einer Vielzahl an Speicherzellen 7. Die lokalen Datenleitungsstreifen 3 weisen mehrere lokalen Datenleitungen 4 auf. Das Zellenfeld 1 hat außerdem Endverstärker 6, an welche je eine Hauptdatenleitung 5 angeschlossen ist. Diese Hauptdatenleitung 5 verläuft senkrecht zu sowohl den Zellenfeldstreifen 2 als auch den lokalen Datenleitungsstreifen 3.

Soll auf eine bestimmte Speicherzelle 7 zugegriffen werden, so muß diese aktiviert werden. Dazu sind mehrere Wortleitungen 11, welche parallel zu den lokalen Datenleitungsstreifen 3 und innerhalb eines bestimmten Zellenfeldstreifens 2 verlaufen, vorgesehen. Des Weiteren sind mehrere Spaltenleitungen 12, welche parallel zu den Hauptdatenleitungen 5 verlaufen und die Wortleitungen 11 in Kreuzungspunkten 13 schneiden, vorgesehen. Jede Speicherzelle 7 lässt sich in eindeutiger Weise einem der Kreuzungspunkte 13 zuordnen. Die Aktivierung eines Kreuzungspunktes 13 geschieht durch Aktivierung der entsprechenden Wort- und Spaltenleitung 11, 12. Ist der Kreuzungspunkt 13 aktiviert, so kann auf die zugeordneten Speicherzellen 7 zugegriffen werden.

Fig. 5 zeigt eine schematische Darstellung des Weges, den ein Bit zurücklegt, wenn es aus einem Speicherbaustein gelesen wird bzw. in einen Speicherbaustein geschrieben wird. Ein in einer Speicherzelle 7 gespeichertes Bit wird, nachdem es über eine Wortleitung 11 und eine Spaltenleitung 12 (vgl. Fig. 4) aktiviert wurde, über eine Bitleitung 8 zu einem Vorverstärker 9 gebracht, welcher auf einer lokalen Datenleitung 4 eines lokalen Datenleitungsstreifens 3 angebracht ist und ein Verbindungsglied zwischen Bitleitung 8 und lokaler Datenleitung 4 darstellt. Das durch den Vorverstärker verstärkte Bit gelangt dann über die lokale Datenleitung 4 auf einen Schalter 10, welcher auf einer Hauptdatenleitung 5 liegt und ein Verbindungsglied zwischen lokaler Datenleitung 4 und Hauptdatenleitung 5 darstellt. Dieser Schalter 10 leitet das Signal über die Hauptdatenleitung 5 zu einem Endverstärker 6 weiter, welcher das Signal auf einen gewünschten Ausgabepegel hebt und anschließend an einen Ausgang des Speicherchips weiterleitet.

Bei "Synchronous-Dynamic-Random-Access-Memory" - Speicherchips (Schreib-Lesespeicher mit synchronen Zugriff, kurz SDRAMs), die auf sechzehn Bit synchron zugreifen, ist es üblich, jeweils vier Speicherzellen 7 einem bestimmten Kreuzungspunkt 13 zuzuordnen (vgl. Fig. 4). Wird also ein Kreuzungspunkt 13 über die Aktivierung der entsprechenden Wortleitung 11 bzw. Spaltenleitung 12 ausgewählt, so werden die zugehörigen vier Speicherzellen 7 aktiviert und die darin gespeicherten Bits über die Bitleitung 8 zu den jeweiligen Vorverstärkern 9 gebracht, bzw. zu speichernde Bits über die Vorverstärker 9 zu den Speicherzellen 7 geliefert.

Durch Aktivierung eines bestimmten Kreuzungspunktes 13 werden also vier Bits gelesen oder geschrieben. Dies bedeutet, dass bei einem Zugriff auf sechzehn Bits genau vier Kreuzungspunkte 13, d. h. genau zwei Wortleitungen 11 sowie zwei Spaltenleitungen 12, aktiviert werden müssen.

Um Datenkollisionen auf den Bitleitungen sowie den lokalen Datenleitungen zu vermeiden, muß deswegen darauf geachtet werden, dass niemals zwei nebeneinander liegende Zellenfeldstreifen 2 bzw. zwei Wortleitungen 11 innerhalb des gleichen Zellenfeldstreifens 2 gleichzeitig aktiviert werden. Dies ist in Figur 3 durch die Pfeilklammern A und B angedeutet, welche jeweils eine der möglichen Kombinationen von aktivierten Zellenfeldstreifen 2 repräsentieren.

Die der Erfindung zugrunde liegende Aufgabe ist es, einen Speicherbaustein gemäß dem Stand der Technik derart weiterzuentwickeln, dass die Zugriffszeit auf eine gewünschte Menge von Bits bei einem synchronen Zugriff minimiert wird.

Diese Aufgabe wird bei einem Speicherbaustein der eingangs genannten Art erfindungsgemäß dadurch gelöst, dass die Schalter derart angeordnet sind, dass die längstmögliche Laufzeit eines Bits in den lokalen Datenleitungen umso kürzer ist, je weiter die lokalen Datenleitungen relativ zu den anderen bei einem synchronen Speicher-Zugriff gleichzeitig benötigten lokalen Datenleitungen von den Endverstärkern entfernt sind.

Vorteilhafte Weiterbildungen ergeben sich insbesondere aus den Unteransprüchen.

Jedes in einer Speicherzelle gespeicherte Bit durchläuft, wenn es aktiviert wurde, einen individuellen Weg zu einem dem Bit zugeordneten Endverstärker Dieser Weg setzt sich hauptsächlich zusammen aus einem Weganteil, den das Bit auf einem lokalen Datenleitungsstreifen zurücklegt, sowie aus einem Weganteil, den es auf einer Hauptdatenleitung zurücklegt. Dies bedeutet, dass die individuellen Wege der einzelnen Bits je nach Lage der Speicherzellen, der zugehörigen Schalter und damit der zugehörigen Endverstärker 6 unterschiedliche Weglängen haben. Die Laufzeiten der einzelnen Bits von der Speicherzelle bis zum Endverstärker sind somit unterschiedlich. Da bei einem synchronen Speicherzugriff die an einen Ausgang des Speicherbausteins gebrachten Bits erst dann weitertransportiert werden können, wenn alle Bits vorliegen, ist das Bit mit der längsten Laufzeit maßgebend für die Zugriffszeit.

Kerngedanke der vorliegenden Erfindung ist es, die individuellen Wege der einzelnen Bits derart zu gestalten, dass individuelle Wege mit hoher Laufzeit vermieden werden. Zum Ausgleich wird die Weglänge der individuellen Wege mit geringer Laufzeit erhöht. Die weitgehende Gleichverteilung der Anzahl von individuellen Wegen mit kurzer, mittlerer und hoher Laufzeit wird also umverteilt in eine geringe Anzahl individueller Wege mit geringer und hoher Laufzeit sowie eine hohe Anzahl von individuellen Wegen mit mittlerer Laufzeit.

Ein weiteres Merkmal der vorliegenden Erfindung ist es, dass die Gestaltung der individuellen Wege vorzugsweise über die Anordnung der Schalter auf den lokalen Datenleitungsstreifen, welche aus lokalen Datenleitungen bestehen, vorgenommen wird. Über die Lage der Schalter kann die Länge des individuellen Weges, den das Bit auf dem lokalen Datenleitungsstreifen zurücklegt, gezielt verändert werden. Die Anordnung der Schalter auf einem lokalen Datenleitungsstreifen, welcher relativ zu den anderen für einen synchronen Speicher-Zugriff gleichzeitig benötigten lokalen Datenleitungsstreifen am Weitesten von den Endverstärkern entfernt ist, ist dabei derart gestaltet, dass diese Schalter soweit wie möglich in der Mitte des lokalen Datenleitungsstreifens liegen. Darüber können maximale Signallaufstrecken und damit maximale Laufzeiten auf den lokalen Datenleitungen vermieden werden, da dann höchstens eine halbe Länge des lokalen Datenleitungsstreifens durchlaufen werden muß.

Diese und weitere Merkmale und Vorteile der Erfindung werden im folgenden unter Bezugnahme auf die nun aufgeführten Figuren näher erläutert. Es zeigen:
Fig. 1 eine Ausführungsform des erfindungsgemäßen Speicherbausteins,
Fig. 2 eine Ausführungsform eines Speicherbausteins gemäß dem Stand der Technik,
Fig. 3 einen schematischen Aufbau eines Speicherbausteines gemäß dem Stand der Technik,
Fig. 4 eine schematische Darstellung von Speicherzellen an zwei Kreuzungspunkten als Einzelheit von Fig. 3, und
Fig. 5 eine schematische Darstellung eines Weges eines Bits von einer Speicherzelle zu einem Endverstärker.

Die Figuren 3 bis 5 sind bereits eingangs erläutert worden. In den Figuren werden einander entsprechende Bauteile mit den gleichen Bezugszeichen versehen.

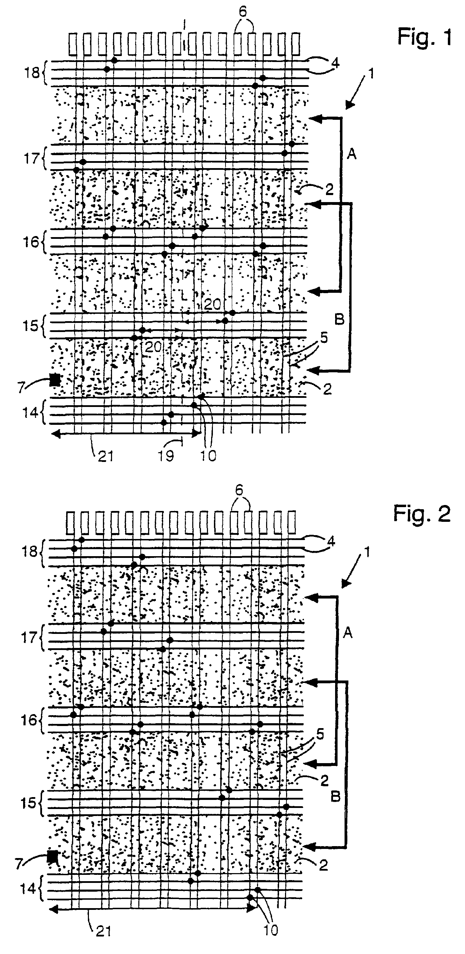

Fig. 1 zeigt eine besonders bevorzugte Ausführungsform eines erfindungsgemäßen Speicherbausteines. Dieser Speicherbaustein ist für den synchronen Zugriff auf sechzehn Bit ausgelegt. Jeweils zwei Schalter 10, die auf einem gleichen lokalen Datenleitungsstreifen 14, 15, 16, 17, 18 liegen, weisen von einer Achse 19 des Speicherbausteines einen gleichen Abstand 20 auf. Je weiter die lokale Datenleitungsstreifen 14, 15, 16, 17, 18 von den Endverstärkern 6 entfernt sind, desto näher liegen die äußeren Schalter 10, welche auf diesen lokalen Datenleitungsstreifen 14, 15, 16, 17, 18 liegen, an der Achse 19. Es ergibt sich so eine V-förmige Anordnungsstruktur der Schalter 10.

Diese Anordnungsstruktur kann sich beispielsweise mit zunehmendem Abstand von den Endverstärkern 6 periodisch wiederholen und ist auch auf Speicherbausteine übertragbar, die einen synchronen Zugriff auf mehr oder weniger als sechzehn Bits, beispielsweise zweiunddreißig Bits, aufweisen.

Da die Schalter 10, welche auf dem lokalen Datenleitungsstreifen 14 liegen, die längste Signallaufzeit bezüglich der Hauptdatenleitung 5 aufweisen, muß für diese die maximale Signallaufstrecke 21 möglichst gering gehalten werden. Dies wird durch die mittige Zentrierung der Schalter 10 bezüglich der Zellenfeldstreifen 2 auf dem lokalen Datenleitungsstreifen 14 erreicht. Somit werden maximale Signallaufstrecken 21, die länger sind als die Hälfte der Länge eines lokalen Datenleitungsstreifens, wie beispielsweise in Fig. 2 gezeigt, vermieden. Damit ist die maximale Laufzeit eines Bits herabgesetzt, was eine höhere Taktrate des Speicherchips ermöglicht.

## Patentansprüche

1. Speicherbaustein mit
- einer Vielzahl von innerhalb eines Zellenfeldes (1) angeordneten Speicherzellen (7),
- die jeweils über eine Bitleitung (8) mit einem Vorverstärker (9), von diesem über eine lokale Datenleitung (4) und eine mit der lokalen Datenleitung (4) durch einen Schalter (10) verbundene Hauptdatenleitung (5) mit einem Endverstärker (6) verbunden sind,
- wobei auf eine Anzahl von n Bits synchron zugegriffen wird,
**dadurch gekennzeichnet,** dass die Schalter (10) derart angeordnet sind, dass die längstmögliche Laufzeit eines Bits in den lokalen Datenleitungen (4) umso kürzer ist, je weiter die lokalen Datenleitungen (4) relativ zu den anderen bei einem synchronen Speicher-Zugriff gleichzeitig benötigten lokalen Datenleitungen (4) von den Endverstärkern (6) entfernt sind.

2. Speicherbaustein nach Anspruch 1, **dadurch gekennzeichnet,** dass das Zellenfeld (1) aus mehreren Zellenfeldstreifen (2) besteht, welche durch zu den Zellenfeldstreifen (2) parallele, beidseitig angrenzende lokale Datenleitungsstreifen (3) voneinander getrennt sind.

3. Speicherbaustein nach Anspruch 2, **dadurch gekennzeichnet,** dass die lokalen Datenleitungsstreifen (3) aus wenigstens vier lokalen Datenleitungen (4) bestehen.

4. Speicherbaustein nach Anspruch 2 oder 3, **dadurch gekennzeichnet,** dass die Hauptdatenleitungen (5) senkrecht zu den Zellenfeldstreifen (2) verlaufen.

5. Speicherbaustein nach Anspruch 4, **dadurch gekennzeichnet,** dass jeweils 2 Schalter (10), die auf demselben lokalen Datenleitungsstreifen (3) liegen, den gleichen Abstand (20) bezüglich einer Achse (19) aufweisen, die parallel zu den Hauptdatenleitungen (5) verläuft und bezüglich der Zellfeldstreifen (2) mittig zentriert ist.

6. Speicherbaustein nach einem der vorigen Ansprüche, **dadurch gekennzeichnet,** dass die Anzahl n von Bits, auf die synchron zugegriffenen wird, gleich acht, sechzehn, zweiunddreißig oder vierundsechzig ist.

7. Speicherbaustein nach Anspruch 6, **dadurch gekennzeichnet,** dass die Anzahl der Endverstärker (6) gleich acht, sechzehn, zweiunddreißig oder vierundsechzig ist.
